Europäisches Patentamt

European Patent Office

Office européen des brevets

(11) Publication number: **0 293 832 B1**

# EUROPEAN PATENT SPECIFICATION

(45) Date of publication of patent specification: **18.03.92**   (51) Int. Cl.⁵: **F02M 21/00**

(21) Application number: **88108693.8**

(22) Date of filing: **31.05.88**

(54) Gas feed system for a gas fired diesel engine.

(30) Priority: **02.06.87 JP 138638/87**

(43) Date of publication of application:
**07.12.88 Bulletin  88/49**

(45) Publication of the grant of the patent:
**18.03.92 Bulletin  92/12**

(84) Designated Contracting States:
**AT DE FR GB SE**

(56) References cited:
**EP-A- 0 069 717**

**PATENT ABSTRACTS OF JAPAN, vol. 11, no.
352 (M-643)[2799], November 18, 1987; & JP-
A-62 131 925 (MITSUBISHI HEAVY IND. LTD)
15-06-1987**

**PATENT ABSTRACTS OF JAPAN, vol. 12, no.
27 (M-662)[2874], January 27, 1988; & JP-A-62
182 468 (MITSUBISHI HEAVY IND. LTD)
10-08-1987**

**PATENT ABSTRACTS OF JAPAN, vol. 11, no.
364 (M-646)[2811], November 27, 1987; & JP-
A-62 139 958 (MITSUBISHI HEAVY IND. LTD)
23-06-1987**

(73) Proprietor: **MITSUBISHI JUKOGYO KABUSHIKI
KAISHA**
**5-1, Marunouchi 2-chome Chiyoda-ku
Tokyo 100(JP)**

(72) Inventor: **Asai, Koetsu c/o Nagasaki
Tech.Inst.Mitsubishi
Jukogyo K.K., 1-1, Akunoura-machi,
Nagasaki-shi
Nagasaki-ken(JP)**
Inventor: **Nakagawa, Hiroshi c/o Nagasaki
Tech.Inst.
Mitsubishi Jukogyo K.K., 1-1, Akunoura-
machi,
Nagasaki-shi, Nagasaki-ken(JP)**
Inventor: **Tateishi, Mataji c/o Nagasaki
Tech.Inst.
Mitsubishi Jukogyo K.K., 1-1, Akunoura-
machi
Nagasaki-shi, Nagasaki-ken(JP)**

(74) Representative: **Henkel, Feiler, Hänzel & Part-
ner**
**Möhlstrasse 37
W-8000 München 80(DE)**

EP 0 293 832 B1

## Description

BACKGROUND OF THE INVENTION:

Field of the Invention:

The present invention relates to a gas feed system for a gas fired diesel engine with a combustion chamber being fed with boil-off gas evaporated from a liquefied gas tank as described in the pre-characterizing portion of claim 1.

Description of the Prior Art:

With regard to the diesel engines making use of gas as a fuel, a low-pressure gas premixing combustion type and a high-pressure gas injection-diffusion combustion type are known, and in the prior art the low-pressure gas premixing combustion type was employed in many cases. This type of method is the method in which a premixed fuel-air mixture is sucked in an intake stroke or a gas fuel is injected into a cylinder over the initial period to the middle period of a compression stroke, in which abnormal combustion is liable to be generated due to temperature rise caused by adiabatic compression during the compression stroke, hence the processing such that a compression ratio is made lower than the diesel engine in the case of operation by an oil fuel was necessitated, and there was a problem that a thermal efficiency and an output power are lowered.

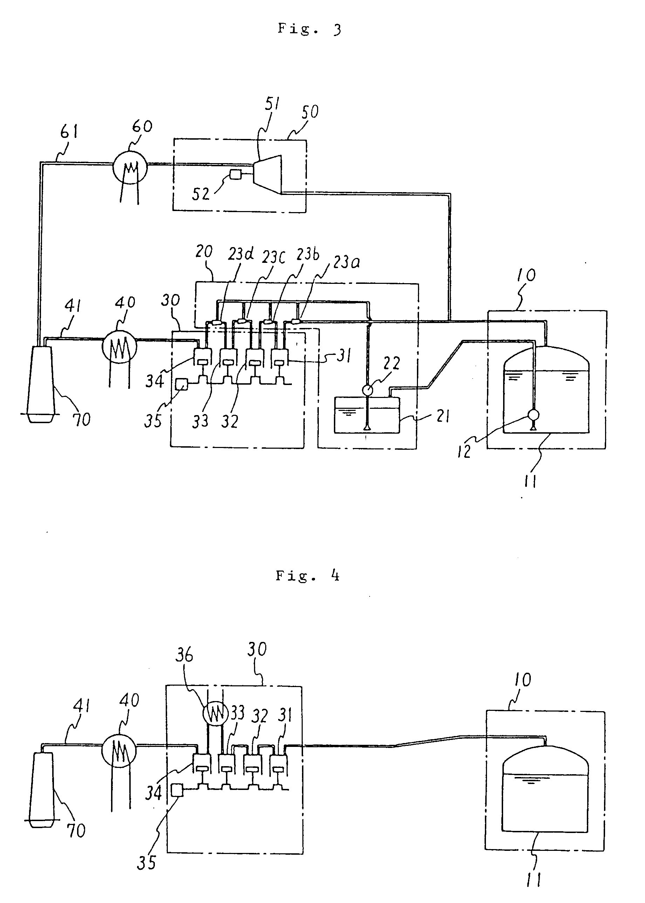

Therefore, developments of the diesel engines of high-pressure gas injection-diffusion combustion type are being carried forward by various companies at present. Fig. 4 shows one example of this high-pressure gas injection-diffusion combustion type of diesel engine in the prior art. With reference to this figure, a gas boiled off from a liquefied natural gas tank 11 is pressurized by a high-pressure compressing apparatus 30, it is cooled down to an ordinary temperature by sea water in a heat-exchanger 40, then it is fed to a diesel engine 70 through a high-pressure gas feed pipe 41. The high-pressure compressing apparatus 30 consists of 4-stage compressing mechanisms 31, 32, 33 and 34 of reciprocating type, which are driven by an electric motor 35. Between the third stage compressing mechanism 33 and the fourth stage compressing mechanism 34 is provided an inter-cooler 36 in which a pressurized gas is cooled by sea water. It is to be noted that reference numeral 10 designates a liquefied gas tank installation.

EP-A-0 069 717 discloses a similar gas feed system for a gas fired diesel engine with a combustion chamber being fed with boil-off gas evaporated from a liquefied gas tank. In this system a first passageway for the gas is provided between a gaseous fuel tank and a high-pressure compressing apparatus.

Further a second passageway for high-pressure gas is provided between the high-pressure compressing apparatus and the combustion chamber of the diesel engine. The high-pressure gas is pressurized by the high-pressure compressing apparatus.

However, in the high-pressure gas injection-diffusion combustion type diesel engine, a lot of power is necessitated for the purpose of pressurizing a gas up to a high pressure. Demonstrating one example of calculation for trial, in the case where from a liquefied natural gas tank having a capacity of 125,000 m$^3$, 0.1% of the total amount boils off per one day, compressor power necessitated for pressurizing the total amount up to 250 bars (atms.) is about 700 kW.

SUMMARY OF THE INVENTION:

It is therefore one object of the present invention to provide a novel gas feed system for a gas fired diesel engine that is free from the above-described disadvantages in the prior art.

A more specific object of the present invention is to provide a gas feed system for a gas fired diesel engine in which power necessitated for pressurization of boil-off gas is little.

According to the present invention, the above described gas feed system further comprises the features of the characterizing portion of claim 1.

Preferred embodiments of the invention are claimed in the dependant claims.

In other words, the above-described problems in the prior art can be resolved owing to the following characteristic features of the invention:

(1) There is provided a passageway through which a part of the gas fed to the diesel engine as a fuel is fed according to a low-pressure gas premixing method, and another passageway through which the remainer is fed according to a high-pressure gas injection method. The amount of gas fed as a low-pressure gas is limited to within such range that abnormal combustion may not be generated in the compression stroke.

(2) A liquefied gas is added to a gas and then they are compressed.

According to the present invention, the following advantages can be obtained:

(1) Since the amount of the high-pressure gas to be used is reduced, the power necessitated for pressurizing into a high-pressure gas becomes little.

(2) The temperature of the boil-off gas at the inlet of the compressing apparatus is lowered. In addition, and the temperature rise of the gas in

2

the course of compression is suppressed to a little, the power necessitated for pressurization becomes little.

The above-mentioned and other objects, features and advantages of the present invention will become more apparent by reference to the following description of preferred embodiments of the invention taken in conjunction with the accompanying drawings.

BRIEF DESCRIPTION OF THE DRAWINGS:

In the accompanying drawings:

Fig. 1 is a system diagram of a gas feed system according to one preferred embodiment of the present invention;

Fig. 2 is a T-S diagram to be referred to for explaining changes of a state of gas in the system shown in Fig. 1;

Fig. 3 is a system diagram of a gas feed system according to another preferred embodiment of the present invention; and

Fig. 4 is a system diagram of a gas feed system in the prior art.

DESCRIPTION OF THE PREFERRED EMBODIMENTS:

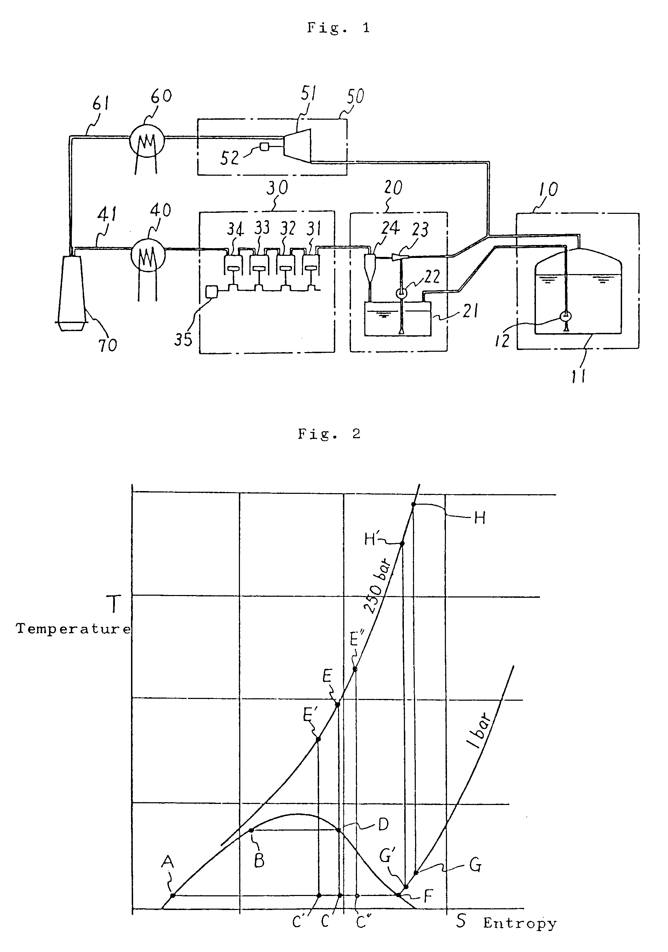

In the following, the present invention will be described in greater detail in connection to the preferred embodiments of the invention. A first preferred embodiment of the invention is illustrated in Fig. 1, which is a system diagram of a gas feed system in which a boil-off gas produced from a liquefied natural gas tank is pressurized and then fed to a diesel engine. Fig. 2 is a T-S diagram of methane to be referred to for explaining change of a state of a boil-off gas in a compression stroke.

In Fig. 1, reference numeral 10 designates a liquefied natural gas tank installation, numeral 20 designates a liquefied gas adding apparatus, numeral 30 designates a high-pressure compressing apparatus, numeral 40 designates a heat-exchanger, numeral 41 designates a high-pressure gas feed pipe, numeral 50 designates a low-pressure compressing apparatus, numeral 51 designates a low-pressure compressor, numeral 52 designates an electric motor, numeral 60 designates a heat-exchanger, numeral 61 designates a low-pressure gas feed pipe, and numeral 70 designates a diesel engine.

Furthermore, reference numeral 11 designates a natural gas tank, numeral 12 designates a liquefied gas transfer pump, numeral 21 designates a service tank, numeral 22 designates a liquefied gas pressurizing pump, numeral 23 designates a liquefied gas adding nozzle, numeral 24 designates a liquid drop classifier, numerals 31, 32, 33 and 34 designate compressing mechanisms, and numeral 35 designates an electric motor.

The liquefied natural gas within the tank 11 is evaporated by the heat continuously entering from the environmental atmosphere into the tank, and thus a boil-off gas is produced. A most part of the boil-off gas is pressurized up to a high pressure by the high-pressure compressing apparatus 30, then it is cooled down to an ordinary temperature by sea water in the heat-exchanger 40, and it is fed to the diesel engine 70 through the high-pressure gas feed pipe 41. The high-pressure compressing apparatus 30 includes four stages of reciprocating type compressing mechanisms 31, 32, 33 and 34, which are driven by the electric motor 35. A part of the boil-off gas is pressurized to a low pressure by the low-pressure compressing apparatus 50, then it is heated up to an ordinary temperature by sea water in the heat-exchanger 60, and it is fed to the diesel engine 70 through the low-pressure gas feed pipe 61.

In the diesel engine 70 are provided a gas injection nozzle, a control valve and the like not shown, and the low-pressure gas is either fed as a premixed fuel-air mixture in the suction stroke of the diesel engine 70 or injected into the cylinder over the initial period and the middle period of the compression stroke. The amount of the low-pressure gas injected at this moment is limited to such range that abnormal combustion caused by temperature rise during the adiabatic compression stroke may not be generated.

The high-pressure gas is momentarily injected into the cylinder in the neighborhood of the upper dead point of the piston. Almost simultaneously with this injection of the high-pressure gas, a pilot oil for ignition use is injected into the cylinder by means of a pilot oil injection device not shown.

The respective basic technology relating to these low-pressure gas feed, high-pressure gas injection and pilot oil injection are well known in connection to diesel engines of low-pressure gas premixing combustion type and high-pressure gas injection-diffusion combustion type.

Referring now to Fig. 2, the ordinate represents a temperature T, and the abscissa represents an entropy S. In this figure, curve A-B represents a saturated liquid line, curve D-F represents a saturated vapor line, curve E-H represents an isobar of 250 bar, and curve A-C-F-G represents an isobar of 1 bar.

In the above-described gas feed system, the liquefied natural gas within the tank 11 is continuously evaporated by heat invasion from the environmental atmosphere, and a boil-off gas is being generated. Prior to pressurization in the high-pressure compressing apparatus 30, the boil off gas is added with a liquefied gas in the liquefied gas adding apparatus 20.

More particularly, the service tank 21 in the above-described liquefied gas adding apparatus 20 receives the liquefied gas transferred from the tank 11 by means of the liquefied gas transfer pump 12. The liquefied gas within the service tank 21 is pressurized by the liquefied gas pressurizing pump 22, and it is injected and added to the boil off gas in a liquefied gas adding nozzle 23.

While the added liquefied gas would evaporate entirely if the injection rate of the liquefied gas is small, if the liquefied gas is injected and added at a higher rate than that necessitated for the temperature of the boil-off gas to be lowered down to the saturated vapor temperature, the mixture takes the state of 2-phase flow consisting of a gas phase of the boil-off gas and a liquid phase of the liquefied gas in the state of minute drops.

Preferably, in the liquid phase the liquid drops should be as minute as possible, and to that end, coarse liquid drops are removed by the liquid drop classifier 24 and returned to the service tank 21. The 2-phase flow having the coarse liquid drops removed is successively pressurized in four stages by the compressing apparatus 30, thereafter it is cooled or heated by sea water in the heat exchanger 40, and then it is fed to the diesel engine 70 as a fuel.

For the purpose of explanation of the change of states of the boil-off gas in the respective procedures with reference to the T-S diagram in Fig. 2, the conditions are assumed as follows: - That is, the change of states is handled under the assumption that the component of the liquefied natural gas is pure methane. Further it is assumed that the temperature of the boil-off gas is 130°K, its pressure is 1 bar, and a pressurized gas having a pressure of 250 bar at the ordinary temperature (about 300°K) is obtained. In addition, it is assumed that the compression is isoentropic adiabatic compression, the boil-off gas and the liquid drops of the injected liquefied gas form an ideally uniform mixed phase, and furthermore, thermal invasion from the environmental atmosphere and mechanical friction or the like are neglected.

The state of the boil-off gas before treatment is represented by point G. If this is pressurized to 250 bar by simply compressing in 4 stages in itself, the state comes to point H. By cooling this down to the ordinary temperature (about 300°K) by sea water while maintaining the constant pressure of 250 bar, the state changes to point E, and the gas is fed to the diesel engine at this state.

The enthalpy difference between G-H is about 170 kcal/kg, and the enthalpy difference between H-E is about 130 kcal/kg. This means that mechanical energy equivalent to about 170 kcal is consumed per 1 kg of boil-off gas and most of the energy of about 130 kcal is wasted as thermal energy in the sea water.

Explaining now the treatment according to the present invention, a liquefied gas at point A is added to a boil-off gas at point G. If the amount of the liquefied gas being added is small, the total amount would evaporate, and the temperature of the boil-off gas is lowered principally by the latent heat of this evaporation and would come to the state between G-F. For instance, it comes to point G'. If this is subjected to 4-stage compression, the state would come to point H'. The enthalpy difference between G'-H' is smaller than the enthalpy difference between G-H.

As the amount of the liquefied gas being injected and added is increased, the temperature of the gas after addition is lowered until it reaches point F. If the amount of addition is further increased, the temperature of the gas after addition would be no more lowered under the temperature of point F, but the gas would become a two-phase fluid consisting of the gas at point F and the liquefied gas at point A.

By way of example, describing now with respect to the case where 0.5 kg of the liquefied gas at point A was added to 1 kg of the boil-off gas at point G, the fluid forming the two-phase flow after injection would come to point C, and if this fluid is compressed in four stages up to 250 bar, it comes to point E, the temperature at point E being about 300°K. Among the compression process from point C to point E, the process from point C to point D is compression in a two-phase flow. Explaining now with respect to a gas phase and a liquid phase separately, the gas phase component is pressurized along the saturated vapor line F-D, on the other hand, the liquid phase component is pressurized and raised in temperature along the saturated liquid line A-B while it is partly evaporating, and as a result of evaporation of the entire amount, the liquid phase component disappears at point B. The enthalpy difference between C-E is about 85 kcal/kg.

In other words, by adding 0.5 kg of the liquefied gas at point A to 1 kg of the boil-off gas at point G, 1.5 kg of two-phase fluid at point C can be obtained. The mechanical energy necessitated for compressing this two-phase fluid to 1.5 kg of the pressurized gas at point E, is equivalent to 85 kcal/kg x 1.5 kg ≒ 130 kcal. As described above, in comparison to the case where the boil-off gas at point G is in itself compressed, the necessary mechanical energy is reduced, and moreover, the obtained amount of the gas at point E is increased to 1.5 folds.

If the amount of the liquefied gas added to 1 kg of the boil-off gas is more than 0.5 kg, the state of the obtained two-phase liquid would shift from point C towards point A, for instance, would come to point C′. On the contrary, if it is less than 0.5 kg, the state would come to point C″. If the gases at these states are compressed up to 250 bar, then they would become the gases at point E′ and at point E″, respectively, hence the temperature of the obtained high-pressure gas would be varied, and also the mechanical energy necessitated for pressurization is decreased or increased, respectively.

If this attained temperature should exceed the allowable range for being fed to the diesel engine 70, then the attained gas is heated or cooled by sea water in the heat-exchanger.

It is to be noted that if the proportion of the liquefied gas to be added to the boil-off gas can be preset in a certain limited range, that is, if the gas temperature at the outlet of the compressing apparatus 30 can be preset within an allowable range, the heat-exchanger 40 could be omitted.

Fig. 3 is a system diagram showing a second preferred embodiment of the present invention.

While the total amount of the liquefied gas to be added was added in the preceding stage before entering the high-pressure pressurizing apparatus in the above-described first preferred embodiment, in the case of this second preferred embodiment, liquefied gas adding nozzles 22a, 23b, 23c and 23d are disposed for the corresponding ones of the 4 stages of compressing mechanisms 31, 32, 33 and 34 in the high-pressure compressing apparatus 30 to successively add the liquefied gas.

In the case of compressing a two-phase fluid, it is desirable that the liquid-phase component should be distributed as uniformly as possible within the gas taking a minute liquid drop state, but to that end it is necessary to add an appropriate amount in sequence rather than adding a large amount of liquefied gas at a time. In the second preferred embodiment, since the liquefied gas adding nozzles 23a, 23b, 23c and 23d are provided respectively for the corresponding ones of the compressing mechanisms 31, 32, 33 and 34, this requirement can be fulfilled relatively easily.

As described in detail above, according to the present invention, with respect to feeding of gas to a diesel engine of the high-pressure gas injection-diffusion combustion type, the characteristic feature exists in that (1) a part of a gaseous fuel is fed according to the low-pressure premixing method, and that (2) a liquefied gas is added to the gaseous fuel and then compressed, and so, as compared to the method in the prior art in which the total amount of gas is fed as a high-pressure gas, mechanical power necessitated for pressurizing the gas becomes little because a part of the gas is fed in a low-pressure gas state owing to the feature (1) above.

In addition, owing to the feature (2) above, the state of gas on the T-S diagram upon compression of the gas is shifted to the low-temperature side as compared to the fuel feed system in the prior art in which a liquefied gas is not added, and hence, power necessitated for pressurization is reduced. Moreover, owing to the combination of the feature (1) and the feature (2) above, under the condition that the amounts of the boil-off gas and the liquefied gas to be added are kept constant, not only the amount of gas to be high-pressure compressed is reduced, but also the state of the gas when it was compressed at a high pressure, is shifted further to the low temperature side, and therefore, the power necessitated for pressurization is further reduced remarkably.

## Claims

1. A gas feed system for a gas fired diesel engine (70) with a combustion chamber being fed with boil-off gas evaporated from a liquified gas tank (11);
   in which a first passageway for the boil-off gas evaporated from said liquified gas tank is provided between said liquified gas tank (11) and a high-pressure compressing apparatus (30);
   and a second passageway (41) for high-pressure gas is provided between the high-pressure compressing apparatus (30) and the combustion chamber of said diesel engine (70); and
   said high-pressure gas is pressurized by said high-pressure compressing apparatus (30);
   characterized in that
   a third passageway (61) for low pressure boil-off gas evaporated from said liquified gas tank is provided between said liquified gas tank (11) and the combustion chamber of said diesel engine (70), with a low pressure compressing apparatus (50) being provided in the third passageway between said liquified gas tank (11) and the combustion chamber of said diesel engine (70);
   a liquefied gas adding apparatus (20) to mix liquefied gaseous fuel pumped from said liquified gas tank (11) with boil-off gas evaporated from said gaseous fuel tank (11) is provided in the first passageway between said liquified gas tank (11) and the high-pressure compressing apparatus (30); and
   the second passageway (41) with high-pressure pressurized gas feeds either boil-off gas or a mixture of boil-off gas and liquefied gas into the combustion chamber of said diesel engine (70).

2. The gas feed system as claimed in claim 1, characterized in that a first heat exchanger (40) is provided in the second passageway (41) between the high-pressure compressing apparatus (30) and the combustion chamber of said diesel engine (70).

**3.** The gas feed system as claimed in claim 1, characterized in that a second heat exchanger (60) is provided in the third passageway (61) between the low-pressure compressing apparatus (50) and the combustion chamber of said diesel engine (70).

## Revendications

**1.** Un système d'alimentation en gaz pour un moteur diesel à gaz (70) avec une chambre de combustion alimentée par un gaz de déperdition évaporé à l'intérieur d'un réservoir de gaz liquéfié (11); dans lequel un premier conduit pour le gaz de déperdition est prévu entre ledit réservoir de gaz liquéfié (11) et un appareil de compression à haute pression (30); et un second conduit (41) pour le gaz à haute pression est prévu entre l'appareil de compression à haute pression (30) et la chambre de combustion dudit moteur diesel (70); et ledit gaz à haute pression est comprimé par ledit appareil de compression à haute pression (30); caractérisé par le fait qu'un troisième conduit (61) a été prévu pour le gaz de déperdition à basse pression évaporé à l'intérieur dudit réservoir de gaz liquéfié (11) entre ledit réservoir de gaz liquéfié (11) et la chambre de combustion dudit moteur diesel (70) avec un appareil de compression à basse pression (50) prévu sur le troisième conduit entre ledit réservoir de gaz liquéfié (11) et la chambre de combustion dudit moteur diesel (70); un appareil d'adjonction de gaz liquéfié (20) pour mélanger le carburant gazeux pompé à l'intérieur du réservoir de gaz liquéfié (11) au gaz de déperdition évaporé à l'intérieur dudit réservoir de gaz liquéfié (11) est prévu dans le premier conduit entre ledit réservoir de gaz liquéfié (11) et l'appareil de compression à haute pression (30); et le second conduit (41) dans lequel circule du gaz comprimé à haute pression fournit soit du gaz de déperdition soit un mélange de gaz de déperdition et de gaz liquéfié dans la chambre de combustion dudit moteur diesel (70).

**2.** Le système d'alimentation en gaz défini à la revendication 1., caractérisé par le fait qu'un premier échangeur de chaleur (40) est prévu dans le second conduit (41) entre l'appareil de compression à haute pression (30) et la chambre de combustion dudit moteur diesel (70).

**3.** Le système d'alimentation en gaz défini à la revendication 1., caractérisé par le fait qu'un second échangeur de chaleur (60) est prévu sur le troisième conduit (61) entre l'appareil de compression à basse pression (50) et la chambre de combustion dudit moteur diesel (70).

## Patentansprüche

**1.** Gaszufuhranlage für einen Diesel-Gasmotor bzw. gasbetriebenen Dieselmotor (70) mit einem Brennraum, der mit aus einem Flüssiggastank (11) verdampftem Absiede- oder Verdampfungsgas speisbar ist, wobei eine erste Leitung für das aus dem Flüssiggastank verdampfte Absiedegas zwischen dem Flüssiggastank (11) und einer Hochdruck-Verdichtervorrichtung (30) Vorgesehen ist, und eine zweite Leitung (41) für Hochdruckgas zwischen der Hochdruck-Verdichtervorrichtung (30) und dem Brennraum des Dieselmotors (70) vorgesehen ist, und das Hochdruckgas durch die Hochdruck-Verdichtervorrichtung (30) unter Druck gesetzt bzw. verdichtet wird, dadurch gekennzeichnet, daß eine dritte Leitung (61) für aus dem Flüssiggastank (11) verdampftes Niederdruckabsiedegas zwischen dem Flüssiggastank (11) und dem Brennraum des Dieselmotors (70) vorgesehen ist, wobei eine Niederdruck-Verdichtervorrichtung (50) in der dritten Leitung zwischen dem Flüssiggastank (11) und dem Brennraum des Dieselmotors (70) angeordnet ist, eine Flüssiggas-Zugabevorrichtung (20) zum Vermischen Von verflüssigtem gasförmigen Kraftstoff, der aus dem Flüssiggastank (11) gefördert wird, mit aus dem Flüssiggastank (11) verdampftem Absiedegas in der ersten Leitung zwischen dem Flüssiggastank (11) und der Hochdruck-Verdichtervorrichtung (30) angeordnet ist und die zweite Leitung (41) mit unter hohen Druck gesetztem Gas entweder Absiedegas oder ein Gemisch aus Absiedegas und Flüssiggas in den Brennraum des Dieselmotors (70) einspeist.

**2.** Gaszufuhranlage nach Anspruch 1, dadurch gekennzeichnet, daß ein erster Wärmetauscher (40) in der zweiten Leitung (41) zwischen der Hochdruck-Verdichtervorrichtung (30) und dem Brennraum des Dieselmotors (70) vorgesehen ist.

**3.** Gaszufuhranlage nach Anspruch 1, dadurch gekennzeichnet, daß ein zweiter Wärmetauscher (60) in der dritten Leitung (61) zwischen der Niederdruck-Verdichtervorrichtung (50) und dem Brennraum des Dieselmotors (70) vorgesehen ist.

EP 0 293 832 B1

Fig. 1

Fig. 2

Fig. 3

Fig. 4